# EUROPEAN PATENT SPECIFICATION

(11) **EP 3 176 944 B1**
(45) Date of publication and mention of the grant of the patent: **16.06.2021**
(21) Application number: 16201017.7
(22) Date of filing: 29.11.2016
(51) Int. Cl.: H03B 17/00

(54) **DEVICE FOR OPTOELECTRONIC OSCILLATOR SIDE-MODE SUPPRESSION**
VORRICHTUNG FÜR OPTOELEKTRONISCHE OSZILLATOR-SEITENMODENUNTERDRÜCKUNG
DISPOSITIF DE SUPPRESSION DE MODE LATÉRAL D'OSCILLATEUR OPTOÉLECTRONIQUE

(30) Priority: 02.12.2015 SI 201500287
(43) Date of publication of application: 07.06.2017
(73) Proprietor: Univerza v Ljubljani, 1000 Ljubljana (SI)
(72) Inventor: BOGATAJ, Luka, 4228 Zelezniki (SI); BATAGELJ, Bostjan, 1000 Ljubljana (SI); VIDMAR, Matjaz, 5000 Nova Gorica (SI)
(74) Representative: Ivancic, Bojan

(56) References cited:
- EP-A1- 2 890 004
- DE-A1- 3 823 008
- US-A1- 2005 057 791
- US-B1- 7 697 579

## Description

The present invention refers to a device for optoelectronic oscillator side-mode suppression, comprising an optical section, an electric section, and a band-pass filter with a feedback loop.

Optoelectronic oscillators have been disclosed in US 2005/057791 A1, DE 38 23 008 A1, US 7 697 579 B1 and EP 2 890 004 A1 for example. With said know solutions the positive feedback loop of the band-pass filter is formed in a manner that the total amplification of the loop created by said feedback loop and said band-pass filter is greater than 1. Thus, two oscillators are present i.e. an entirely electrical oscillator and an optoelectronic oscillator that are mutually locked. It is a drawback of said known solution that the electrical oscillator created by the band-pass filter and the feedback loop thereof increases the phase noise. Therefore, due to the electrical oscillator the phase noise is greater as it would be in a case of the optoelectronic oscillator only.

It is the object of the present invention to create an optoelectronic oscillator comprising a band-pass filter with a feedback loop according to claim 1 and a method of tuning this device according to claim 2.

The invention will be more readily understood on reading the following description of a nonlimiting embodiment and with reference to the accompanying drawings where
Fig. 1 shows a schematic view of an optoelectronic oscillator comprising a band-pass filter with a feedback loop according to the invention,
Fig. 2 shows an available spectrum of the optoelectronic oscillator.

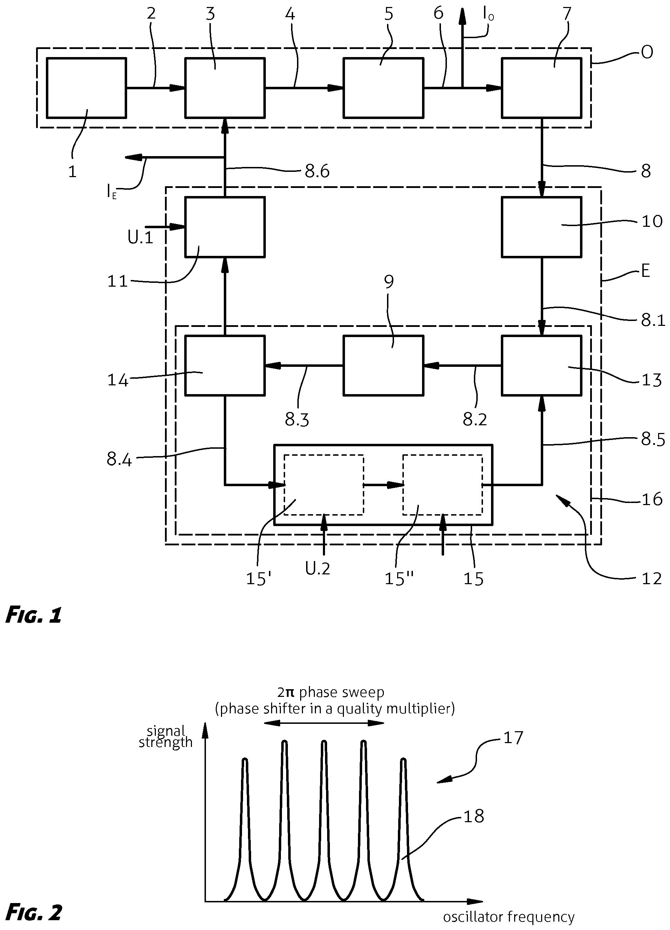

A schematic view of an optoelectronic oscillator is shown in Fig. 1. A light source 1 which is selected as a laser, for instance, generates a signal carrier 2 of an optoelectronic oscillator to be transferred via optical delay line. Said signal carrier 2 is transferred from the light source 1 into a modulator 3 the task thereof is to modulate the carrier 2 with the oscillator signal. When direct laser modulation is utilized, than it is possible for the modulator 3 to constitute a part of the light source 1. An optical signal 4 which in essence represents said carrier 2 modulated by the oscillator signal is further transferred as a signal 6 of the optoelectronic oscillator via delay means 5 to a photo detector 7. Said delay means 5 is selected for example as an optical fibre having the respective length, an optical resonator and similar. By means of the photo detector 7 said carrier 2 is removed from the signal 6 of the optoelectronic oscillator and, as a result, only an oscillator signal 8 is present at the output from the photo detector 7. Afterwards, said oscillator signal 8 is led through a band-pass filter 9 back to said modulator 3. An oscillator loop is closed in this manner. In addition, an amplifier 10, optionally an adjustable amplifier, is provided between said photo detector 7 and said filter 9, whereas a phase shifter 11, preferably an adjustable phase shifter, is additionally provided between said filter 9 and said modulator 3.

Obviously, according to the present invention it is possible to provide another arrangement of the amplifier 10 and the phase shifter 11. The amplifier 10 and the phase shifter 11 can be placed in an arbitrary order directly one after another, for example. Furthermore, the amplifier 10 is placed directly in succession to the photo detector 7, and followed by the phase shifter 11 and said filter 9, for instance.

Said amplifier 10 can be either optical or electric amplifier, however, it can also be part of the modulator 3 and/or photo detector 7. In case the amplifier 10 is selected as the optical amplifier, it must be located in the optical section between the modulator and the photo detector. The optical path with the amplification could be implemented without the amplifier in the oscillator loop. The band-pass filter 9 can optionally be placed in the optical section O of the oscillator, however, the preferred embodiment refers to the filter 9 placed in the electric section E of the oscillator.

Electric output I_{E} may be arranged anywhere in the electric section E. In order to split signal of the oscillator to said output one can use a power divider, a directional coupler and similar. Optical output I_{O} may be arranged anywhere in the optical section O between the modulator 3 and the photo detector 7. In order to split optical signal to said optical output I_{O} one can use an optical directional coupler, for example.

It is provided for according to the present invention, that a feedback loop 12 is located in the electric section E of the optoelectronic oscillator and in parallel to the band-pass filter 9. Said feedback loop 12 comprises means 13 for coupling signal arranged between said amplifier 10 and directly in front of said filter 9, and means 14 for dividing signal, such as a splitter for instance, arranged directly after said filter 9 between the latter and said phase shifter 11. Here, it is provided that said means 13 for coupling signal is selected as combiner, and said means 14 for dividing signal is selected as splitter. Furthermore, according to the present invention is provided that means 15 for processing signal is located between said combiner 13 and said splitter 14. Said means 15 comprise at least an amplifier 15' and/or at least a phase shifter 15". Said oscillator signal 8 exiting said photo detector 7 is lead through said amplifier 10 and, afterwards, a processed signal 8.1 is fed through said combiner 13 as a combined signal 8.2 into said band-pass filter 9. A filtered signal 8.3 exiting said filter 9 is fed into said splitter 14 where it is split into two parts. A first part of the filtered signal 8.3 is returned via said phase shifter 11 as a wanted signal 8.6 to the modulator 3. A second par of the filtered signal 8.3 is fed as a feedback signal 8.4 into said means 15 for signal processing where from it is lead as a processed feedback signal 8.5 back to said combiner 13 where said feedback signal 8.5 is combined with the signal 8.1 coming from said amplifier 10. With another words, the signal originating in the filter 9 is resent through the same filter 9. The unit which is comprised of the band-pass filter 9 and said feedback loop 12 serves as a quality multiplier 16 of the band-pass filter 9.

It is not allowed for the closed loop created by the filter 9 and said feedback loop 12 to oscillate by itself. In fact, said quality multiplier 16 and, respectively, said feedback loop 12 added to the filter 9 form a positive feedback loop, however, the amplification of the entire loop is smaller than "1". Consequently, oscillation is disabled. In spite of that, phase noise of such an optoelectronic oscillator increases, however, for a smaller degree as if the amplification of the entire loop of the quality multiplier 16 would be grater that "1".

If the path travelled by the signal from the output of the filter 9 via said feedback loop 12 to the input of the filter 9 complies with required phase and power, respectively, additional phase treatment of the signal is not necessary. With said feedback loop 12, means 15 for signal processing is superfluous, if the signal 8.5 also complies with required phase and power, respectively.

When set properly, the optoelectronic oscillator comprising the feedback loop 12 and the quality multiplier 16, respectively, behaves as an ordinary optoelectronic oscillator comprising the band-pass filter 9 without the quality multiplier 16, which makes it possible to obtain very small bandwidth of the quality multiplier 16. The bandwidth of said quality multiplier 16 is determined by amplification of said feedback loop 12 of the filter 9, wherein said amplification of the feedback loop 12 must be set in a manner that the amplification of the entire loop of the quality multiplier 16 is less than "1". In case said amplification is greater than "1" the quality multiplier 16 starts to osculate. The bandwidth narrowness of the quality multiplier 16 depends on the control precision of the said amplification of said feedback loop 12 and, respectively, the loop of the quality multiplier 16. The closer to the value "1" lies the amplification of said loop the narrower is the quality multiplier 16. Thus, for instance, the bandwidth with the amplification of "0,9" is smaller than the bandwidth with the amplification of "0,8".

The feedback loop 12 of the band-pass filter 9 has impact both on the bandwidth of the quality multiplier 16 and the insertion loss of the quality multiplier 16. The narrower the bandwidth of the quality multiplier 16 the lower the insertion loss of the quality multiplier 16. The insertion loss can grow above "1", resulting in the amplifier 10 in the loop of the optoelectronic oscillator to become entirely superfluous.

Besides on the conditions in said feedback loop of the filter 9 and, respectively, on the settings of the feedback loop 12 the insertion loss and the bandwidth of the quality multiplier 16 also depend on operating of the rest of the optoelectronic loop. It is the key factor for the occurrence of the oscillation that the amplification of the entire loop of the optoelectronic oscillator comprises the exact value of "1" i.e. a so called Barkhausen amplitude criterion. The saturation power of the oscillator elements usually acts as a mechanism which limits the amplification. It is understood that the greater the signal power inside the oscillator the lesser is the amplification. Thus, the signal power increases as long as the amplification of the loop decreases to the value of precisely "1".

In principle, the band-pass filter 9 comprising the feedback loop 12, or the quality multiplier 16 can be adjusted by itself and without any additional optoelectronic loop. The quality multiplier 16 can be set to a required bandwidth and to the central frequency by means of a circuit analyser. In theory, the quality multiplier 16 set in this manner could be inserted into the optoelectronic oscillator where it would retain its properties. However, this is not entirely true in the practice.

Namely, connection impedances of the optoelectronic loop for the quality multiplier 16 are not equal to input and output impedances of the circuit analyser. The difference influences the operation of the feedback loop 12. In addition, the Barkhausen amplitude criterion and the relation between the amplification of the entire loop and the saturation power inside the feedback loop 12 is also to be taken into account. Due to said fact, the quality multiplier 16 and the optoelectronic oscillator must be tuned according to a method described in the continuation.

In order to carry out the tuning method the external control of the oscillator parameters must be enabled. Said parameters comprise the phase of the entire loop of the oscillator and the amplification of the feedback loop 12 of the filter 9. For this reason, a means 15 for signal treatment is added to the optoelectronic oscillator at least in said feedback loop 12. As already mentioned above, said signal treatment means 15 is selected at least as an amplifier 15' and/or at least as a phase shifter 15". The presence of the phase shifter 11 in the oscillator loop is optional, since the phase can be varied in several ways. So for instance, the phase can be varied by varying the wavelength of the light, the bias of the modulator 3 and similar. The phase shifter 15" in the signal treatment means 15 arranged in the feedback loop 12 can be any arbitrary phase shifter which enables phase variations of the electric signal. The amplifier 15' which enables amplification variations in the feedback loop 12 is selected, for example, as an amplifier with adjustable amplification, or as an amplifier with a fixed amplification having additional adjustable attenuator.

The method of tuning the optoelectronic oscillator having the quality multiplier 16 comprises the following steps.

The first step comprises connecting the optoelectronic oscillator to a spectrum analyser. Said connection is possible directly via the electric output or indirectly via the optical output.

Afterwards, the amplification of the feedback loop 12 is set in a manner that the amplification of the entire loop of the quality multiplier 16 is greater than "1". As a result, the quality multiplier 16 begins to oscillate.

The previous step is followed by setting said spectrum analyser to the appropriate frequency range of the optoelectronic oscillator so that the oscillator signal can be observed on the spectrum analyser. Than, the optical path is disconnected. The signal can still be observed on the spectrum analyser, however, the signal observed is now the signal of the oscillating filter 9 having the feedback loop 12, and, respectively, the quality multiplier 16. Said disconnection of the optical path can be carried out in the manner that a connection from the modulator 3 to the delay means 5, or from the delay means 5 to the photo detector 7 is disconnected. The optical path, for instance, can be disconnected by removing an optical connector at the photo detector 7. The amplification of the feedback loop 12 is lowering until the quality multiplier 16 stops oscillating. At that point no signal can be detected by the spectrum analyser.

Further, the entire 2π section of the phase shifter 15" in the feedback loop 12 is swept. In case the feedback loop 12 oscillates at the specific setting of the phase shifter 15" the entire 2π section of the phase shifter in the loop of the optoelectronic oscillator is to be swept again. If the signal is absent, the method continues with the next step, otherwise the method returns to the step of lowering the amplification of the feedback loop 12.

Afterwards, the optical path is re-connected again and the entire 2π section of the phase shifter 15" in the feedback loop 12 is swept and, simultaneously, spectrum of the oscillator signal is recorded. The result of the recording is a comb-like frequency spectrum 17 with one or more frequency peaks 18 (Fig. 2). If at least one of said frequency peaks 18 is not present, the step must be repeated in which the amplification of the loop of the quality multiplier 16 is set to the value above "1" in order for the quality multiplier 16 starts to oscillate. Every alteration of the phase shifter 15" in the feedback loop 12 changes frequency spectrum 17 of the signal of the oscillator. The result of the spectrum 17 recording is a sum of spectra with each value of the phase shifter 15", for example. The spectrum 17 can be recorded with a spectrum analyser.

Said frequency spectrum 17 and, respectively, the available spectrum of the optoelectronic oscillator obtained by recording the oscillator spectrum during phase alteration in the feedback loop 12 is described in detail with the reference to Fig. 2. The present embodiment shows the number of said frequency peaks 18 equal to five. The number of the frequency peaks 18 depends on how much larger than "1" is the oscillator's open loop amplification.

If the number of the frequency peaks 18 is even, the value U.1 of the phase shifter 11 in the main loop of the oscillator must be altered and repeated the step in which the entire 2π section of the phase shifter 15" in the feedback loop 12 is swept and, simultaneously, spectrum of the oscillator signal is recorded. The phase shifter 11 shifts the available frequency spectrum 17. Only those frequency peaks 18 appear that overlap with the bandwidth of the band-pass filter 9 without the feedback loop 12. However, since one of the frequency peaks 18 in the available spectrum 17 is to be precisely in the centre of the bandwidth of the filter 9, the number of the peaks 18 must be odd.

If the number of the frequency peaks 18 is odd, the value U.2 is used to set the frequency of the oscillator to the central peak 18 by means of the phase shifter 15" in the feedback loop 12. Setting the frequency to the central peak 18 is carried out in a manner that the value U.2 of the phase shifter 15" in the feedback loop 12 is varied and the signal spectrum 17 is compared with the recorded image obtained in the step in which the entire 2π section of the phase shifter 15" in the feedback loop 12 is swept and, simultaneously, spectrum of the oscillator signal is recorded. The tuning is ended when the signal spectrum 17 is located in the central peak 18 of the recording.

## Claims

1. Optoelectronic oscillator configured for side-mode suppression, comprising an optical section (O), an electric section (E),
wherein the optoelectronic oscillator is made up of a closed loop comprising the optical (O) and the electrical section (E),
wherein the optical section comprises a modulated light source (1, 3) or a light source (1) followed by a modulator (3), optical delay means (5), and a photo detector (6),
wherein the electrical section (E) comprises a main loop including a bandpass filter (9), an amplifier (10), a first adjustable phase shifter (11) and a feedback-loop (12),
***characterized in that***
said feedback loop (12) comprises means (13) for signal coupling arranged directly in front of said band-pass filter (9), means (14) for signal splitting arranged directly after said band-pass filter (9), and means (15) for signal processing provided between said means (13) for signal coupling and means (14) for signal splitting,
wherein said means (15) for signal processing comprise an adjustable amplifier (15') and a second adjustable phase shifter (15") and said feedback loop (12) is
connected in parallel to the band-pass filter (9) in the electric section (E) and wherein the amplification of a loop provided by the filter (9) and the feedback loop (12) is less than "1", and wherein a unit comprising the band-pass filter (9) and said feedback loop (12) forms a quality multiplier (16) of the band-pass filter (9).

2. A method of tuning the optoelectronic oscillator according to claim 1, wherein the method comprises the following steps:
a) connecting the optoelectronic oscillator to a spectrum analyser via an electric
output anywhere in the electric section;
b) setting the amplification in said feedback loop (12) to a value greater than "1" in order for said said quality multiplier (16) to begin to oscillate;
c) setting the spectrum analyser in order to observe the signal of the oscillator;
d) disconnecting a connection from the modulator (3) to the delay means (5), or from the delay means (5) to the photo detector (7) in the optical section (O) in order to observe in the spectrum analyser a signal from said quality multiplier (16);
e) lowering the amplification of said feedback loop (12) in order for said quality multiplier (16) to stop oscillating;
f) sweeping the entire 2π section of said second adjustable phase shifter (15") in said feedback
loop (12);
g) returning to step e) if said quality multiplier (16) oscillates at a specific setting of said second adjustable phase shifter (15") in said feedback loop (12);
h) re-connecting the optical section (O);
i) sweeping the entire 2π section of said phase shifter (15") in said feedback loop (12) and, simultaneously, recording said frequency spectrum (17) of the oscillator signal;
j) returning to step b) if the frequency spectrum which is a result of said recording does not comprise at least one frequency peak;
k) altering a value (U.1) of said first adjustable phase shifter (11) in the main loop of the oscillator, if the number of said frequency peaks is even, and repeating the step i);
l) setting the frequency of the oscillator to a central frequency peak by means of said second adjustable phase shifter (15") in said feedback loop (12), if the number of said frequency peaks is odd.

## Patentansprüche

1. Optoelektronischer Oszillator, der für die Seitenmodenunterdrückung konfiguriert ist und einen optischen Abschnitt (O) und einen elektrischen Abschnitt (E) umfasst,
wobei der optoelektronische Oszillator aus einer geschlossenen Schleife gemacht ist, die den optischen (O) und elektrischen Abschnitt (E) umfasst,
wobei der optische Abschnitt eine modulierte Lichtquelle (1,3) oder eine Lichtquelle (1) gefolgt von einem Modulator (3), optischen Verzögerungsmitteln (5) und einen Photodetektor (6) umfasst,
wobei der elektrische Abschnitt (E) eine Hauptschleife einschließlich eines Bandpassfilters (9), eines Verstärkers (10), eines anpassbaren Phasenschiebers (11) und einer Rückkopplungsschleife (12) umfasst,
**dadurch gekennzeichnet, dass**
die Rückkopplungsschleife (12) Mittel (13) zur Signalkopplung, die direkt vor dem Bandpassfilter (9) angeordnet sind, Mittel (14) zum Teilen des Signals, die direkt nach dem Bandpassfilter (9) angeordnet sind, und Mittel (15) zur Signalverarbeitung umfasst, die zwischen den den Mitteln (13) zur Signalkopplung und den Mitteln (14) zum Teilen des Signals angeordnet sind,
wobei die Mittel (15) zur Signalverarbeitung einen anpassbaren Verstärker (15') und einen zweiten anpassbaren Phasenschieber (15") umfassen und die Rücckopplungsschleife (12) parallel zu dem Bandpassfilter (9) in dem elektrischen Abschnitt (E) verbunden ist und
wobei die Verstärkung einer Schleife, die durch den Filter (9) und und die Rücckopplungsschleife (12) bereitgestellt wird, kleiner als "1" ist und wobei eine Einheit, die den Bandpassfilter (9) und die Rückkopplungsschleife (12) einen Güte-Multiplikator (16) des Bandpassfilters (9) bildet.

2. Verfahren zur Abstimmung des optoelektronischen Oszillators nach Anspruch 1, wobei das Verfahren die folgenden Schritte umfasst:
a) Anschließen des optoelektronischen Oszillators an einen Spektrumanalysator über einen elektrischen Ausgang irgendwo im elektrischen Abschnitt;
b) Einstellen der Verstärkung in der Rückkoppelungsschleife (12) auf einen Wert größer als "1", damit der Güte-Multiplikator (16) zu schwingen beginnt;
c) Einstellen eines Spektrumanalysators, um das Signal des Oszillators zu beobachten;
d) Trennen einer Verbindung von dem Modulator (3) zu den Verzögerungsmitteln (5) oder von den Verzögerungsmitteln (5) zu dem Photodetektor (7) in dem optischen Abschnitt (O), um im Spektrumanalysator ein Signal des Güte-Multiplikators (16) zu beobachten;
e) Absenken der Verstärkung der Rückkopplungsschleife (12), damit der Güte-Multiplikator (16) aufhört zu schwingen;
f) Wobbeln des gesamten 2π-Abschnitts des zweiten anpassbaren Phasenschiebers (15") in der Rückkopplungsschleife (12);
g) Rückkehr zu Schritt e), wenn der Güte-Multiplikator (16) bei einer bestimmten Einstellung des zweiten anpassbaren Phasenschiebers (15') in der Rückkoppelungsschleife (12) schwingt;
h) Wieder - Verbinden des optischen Abschnitts (O);
i) Wobbeln des gesamten 2π-Abschnitts des Phasenschiebers (15") in der Rücckopplungsschleife (12) und gleichzeitiges Aufzeichnen des Frequenzspektrums (17) des Oszillatorsignals;
j) Rückkehr zu Schritt b), wenn das Frequenzspektrum, welches ein Ergebnis der genannten Aufzeichnung ist, nicht zumindest eine Frequenzspitze umfasst;
k) Ändern eines Wertes (U.1) des ersten anpassbaren Phasenschiebers (11) in der Hauptschleife des Oszillators, wenn die Anzahl der Frequenzspitzen gerade ist, und Wiederholen des Schrittes i);
l) Einstellen der Frequenz des Oszillators auf eine zentrale Frequenzspitze mit Hilfe des zweiten anpassbaren Phasenschiebers (15") in der Rückkopplungsschleife (12), wenn die Anzahl der Frequenzspitzen ungerade ist.

## Revendications

1. Oscillateur optoélectronique configuré pour une suppression de mode latéral, comprenant une section optique (0), une section électrique (E),
dans lequel l'oscillateur optoélectronique est composé d'une boucle fermée comprenant la section optique (0) et la section électrique (E),
dans lequel la section optique comprend une source de lumière modulée (1, 3) ou une source de lumière (1) suivie d'un modulateur (3), des moyens de retard optique (5) et un photodétecteur (6),
dans lequel la section électrique (E) comprend une boucle principale comprenant un filtre passe-bande (9), un amplificateur (10), un premier déphaseur réglable (11) et une boucle de rétroaction (12),
**caractérisé par le fait que**
ladite boucle de rétroaction (12) comprend des moyens (13) pour un couplage de signal agencés directement devant ledit filtre passe-bande (9), des moyens (14) pour une division de signal agencés directement après ledit filtre passe-bande (9), et des moyens (15) pour un traitement de signal disposés entre lesdits moyens (13) pour un couplage de signal et lesdits moyens (14) pour une division de signal,
dans lequel lesdits moyens (15) pour un traitement de signal comprennent un amplificateur réglable (15') et un second déphaseur réglable (15") et ladite boucle de rétroaction (12) est connectée en parallèle au filtre passe-bande (9) dans la section électrique (E) et
dans lequel l'amplification d'une boucle fournie par le filtre (9) et la boucle de rétroaction (12) est inférieure à « 1 », et dans lequel une unité comprenant le filtre passe-bande (9) et ladite boucle de rétroaction (12) forme un multiplicateur de qualité (16) du filtre passe-bande (9).

2. Procédé d'accord de l'oscillateur optoélectronique selon la revendication 1, dans lequel le procédé comprend les étapes suivantes :
a) connecter l'oscillateur optoélectronique à un analyseur de spectre par l'intermédiaire d'une sortie électrique n'importe où dans la section électrique ;
b) régler l'amplification dans ladite boucle de rétroaction (12) à une valeur supérieure à « 1 » afin que ledit multiplicateur de qualité (16) commence à osciller ;
c) régler l'analyseur de spectre afin d'observer le signal de l'oscillateur ;
d) déconnecter une connexion du modulateur (3) aux moyens de retard (5), ou des moyens de retard (5) au photodétecteur (7) dans la section optique (0) afin d'observer dans l'analyseur de spectre un signal provenant dudit multiplicateur de qualité (16) ;
e) abaisser l'amplification de ladite boucle de rétroaction (12) afin que ledit multiplicateur de qualité (16) cesse d'osciller ;
f) balayer toute la section 2π dudit second déphaseur réglable (15") dans ladite boucle de rétroaction (12) ;
g) revenir à l'étape e) si ledit multiplicateur de qualité (16) oscille à un réglage spécifique dudit second déphaseur réglable (15") dans ladite boucle de rétroaction (12) ;
h) reconnecter la section optique (0) ;
i) balayer toute la section 2π dudit déphaseur (15") dans ladite boucle de rétroaction (12) et, simultanément, enregistrer ledit spectre de fréquences (17) du signal d'oscillateur ;
j) revenir à l'étape b) si le spectre de fréquences qui est un résultat dudit enregistrement ne comprend pas au moins un pic de fréquence ;
k) modifier une valeur (U.1) dudit premier déphaseur réglable (11) dans la boucle principale de l'oscillateur, si le nombre desdits pics de fréquence est pair, et répéter l'étape i) ;
l) régler la fréquence de l'oscillateur à un pic de fréquence central au moyen dudit second déphaseur réglable (15") dans ladite boucle de rétroaction (12), si le nombre desdits pics de fréquence est impair.
